# EUROPÄISCHE PATENTSCHRIFT

(11) **EP 1 372 186 B1**
(45) Veröffentlichungstag und Bekanntmachung des Hinweises auf die Patenterteilung: **10.12.2008**
(21) Anmeldenummer: 03018179.6
(22) Anmeldetag: 31.10.2000
(51) Int. Cl.: H01L 21/00

(54) **Vorrichtung zur Flüssigkeitsbehandlung von scheibenförmigen Gegenständen**
Apparatus for liquid treatment of wafers
Dispositif de traitement de plaquettes

(43) Veröffentlichungstag der Anmeldung: 17.12.2003
(62) Teilanmeldung aus: 00123714.8
(73) Patentinhaber: SEZ AG, 9500 Villach (AT)
(72) Erfinder: Engesser, Philipp, Dipl.-Ing. (FH), 88131 Lindau (DE)
(74) Vertreter: Kontrus, Gerhard

(56) Entgegenhaltungen:
- EP-A- 0 444 714
- EP-A- 0 844 646
- EP-A- 1 052 682
- US-A- 5 705 223
- US-A- 5 904 164
- PATENT ABSTRACTS OF JAPAN Bd. 015, Nr. 102 (E-1043), 12. März 1991 (1991-03-12) -& JP 02 309638 A (FUJITSU LTD), 25. Dezember 1990 (1990-12-25)

## Beschreibung

Die Erfindung betrifft eine Vorrichtung und ein Verfahren zur Flüssigkeitsbehandlung eines definierten Bereiches einer Hauptoberfläche eines scheibenförmigen Gegenstandes, insbesondere eines Wafers.

Der Grund für eine Behandlung eines definierten, randnahen Abschnitts eines scheibenförmigen Gegenstandes, insbesondere eines Wafers, soll im folgenden beschrieben werden.

Ein Wafer; beispielsweise ein Siliziumwafer, kann beispielsweise allseitig eine Beschichtung von Siliziumdioxid aufweisen. Für nachfolgende Prozesse (wenn zum Beispiel eine Göldschicht oder eine Schicht aus Polysilizium (polykristallinem Silizium) aufgebracht werden soll) kann es notwendig sein, den Wafer zumindest im Randbereich einer Hauptoberfläche, gegebenenfalls aber auch im Bereich seiner Umfangsfläche und/oder der zweiten Hauptoberfläche von der vorhandenen Beschichtung zu befreien. Dies geschieht durch Ätzverfahren, die sich vor allem in Trockenätzverfahren und Nassätzverfahren untergliedern lassen. Auch kann es erwünscht sein, ein zuvor galvanisch aufgebrachtes Metall (z.B. Kupfer) von bestimmten Bereichen einer Hauptoberfläche eines Halbleitersubstrates zu entfernen. In diesem Fall kann dieser Bereich entweder ein ringförmiger, randnaher Abschnitt sein, oder genau der Bereich der vorderen Hauptoberfläche (Hauptoberfläche auf der sich die Strukturen befinden = device side, in dem sich keine Strukturen befinden, d.h. der chipfreien Zone.

Eine weitere Anwendung ist die Reinigung von Wafern. Hier kann es notwendig sein, den Wafer zumindest im Randbereich einer Hauptoberfläche, gegebenenfalls aber auch im Bereich seiner Umfangsfläche und/oder der zweiten Hauptoberfläche zu reinigen, d.h. von Partikeln und/oder anderen Kontaminationen zu befreien. Dies geschieht durch Nassreinigungsverfahren.

Eine weitere Flüssigkeitsbehandlung ist das Aufbringen von Schichten wie z.B. das galvanische Auftragen von Metallen (Electro-Plating). Dies kann mit oder ohne Strom geschehen, wobei man im letzteren Fall vom "Electroless Electroplating" spricht.

Die Erfindung ist auf das Nassätzen, Nassreinigen oder nasschemische Auftragen von Schichten (zusammengefasst unter dem Begriff Flüssigkeitsbehandlung) gerichtet. Dabei wird der zu behandelnde Flächenabschnitt des Wafers mit der Behandlungsflüssigkeit benetzt und die zu entfernende Schicht bzw. die Verunreinigungen abgetragen oder in diesem Flächenabschnitt eine Schicht aufgebracht.

Während der Flüssigkeitsbehandlung kann der scheibenförmige Gegenstand entweder still stehen oder rotieren (z.B. um seine Achse).

Um zu verhindern; dass die Behandlungsflüssigkeit unkontrolliert auf die nicht zu behandelnde Oberfläche gelangt, wird in der EP 0 316 296 B1 ein Träger (Chuck) vorgeschlagen, der die nicht zu behandelnde, dem Träger zugewandte Oberfläche mit einem Gas spült. Dabei tritt das Gas zwischen der Waferkante und dem Träger aus.

Die JP 09-181026 A beschreibt einen Träger für Halbleiterscheiben der außerhalb einer Ringdüse eine besondere Form, z.B. eine ringförmige, nach außen hin abfallende Stufe oder eine Abschrägung seines Randes, aufweist. Auch wird eine Einsaugöffnung vorgeschlagen. Durch. diese Formgebung bzw. die Einsaugöffnung soll die Strömungsgeschwindigkeit im Randbereich beeinflußt (verringert) werden. Dies soll dazu dienen, daß die von oben aufgebrachte Behandlungsflüssigkeit über den Rand des Wafers hinaus auf die dem Chuck zugewandte Seite fließt und dort einen Randbereich behandelt.

Unabhängig davon, ob nun eine Einrichtung zur Aufnahme des scheibenförmigen Gegenstandes (Träger bzw. Chuck) nach EP 0 316 296 B1 oder JP 09-181026 A (englisches Abstract) verwendet wird, kann auf der dem Träger zugewandten Hauptoberfläche maximal ein Randbereich von 1,5 mm (gemessen vom äußeren Rand des Wafers) behandelt werden. Die Flüssigkeit fließt danach wieder in Richtung Waferkante und wird von dieser abgeschleudert. Dieser behandelte Randbereich ist in keinem der beiden Fälle bewußt definiert, vielmehr ist es ein Zufallsergebnis, da die Größe des Randbereiches wesentlich, von einer Vielzahl von teilweise einander gegenseitig beeinflussenden Parametern abhängt, wie z.B. Oberflächenbeschaffenheit (Rauhigkeit, Art und Dicke der Adsorptionsschichten), Temperatur, Druck, Luftfeuchtigkeit, etc.

In der US 4,838,289 A wird ein System zum Randätzen eines Wafers beschrieben, bei dem eine Düse gegen den zu ätzenden Bereich der Waferoberfläche gerichtet ist, während der Wafer rotiert. Nachteil dieses Systems ist es, dass der zu behandelnde Bereich nicht genau definiert ist und auch Flüssigkeit auf den Bereich der nicht behandelt werden soll gelangen kann.

Dementsprechend liegt nun der Erfindung die Aufgabe zugrunde, eine Möglichkeit aufzuzeigen, auf einer Oberfläche eines scheibenförmigen Gegenstandes einen definierten Abschnitt mit einer.Flüssigkeit zu behandeln, wobei es u.a. auch möglich sein soll einen Randbereich von über 2 mm (gemessen vom äußeren Rand des scheibenförmigen Gegenstandes) zu behandeln. Bei diesem definierten Abschnitt kann es sich auch um einen innen liegenden Bereich einer Oberfläche des scheibenförmigen Gegenstandes handeln, d.h. ein Bereich, der nicht bis zum Rand des scheibenförmigen Gegenstandes reicht. Wenn auch hier jeweils ein Bereich der von einer Kreislinie nach außen und/oder innen begrenzt ist, so ist dies dennoch nicht notwendig; der zu behandelnde Bereich kann auch z.B. durch ein Vieleck begrenzt sein. Diese Begrenzungslinie kann, wenn es sich bei dem scheibenförmigen Gegenstand um einen Halbleiterwafer handelt, dem Bereich der Oberfläche auf dem sich die Chips befinden ("device area") entsprechen: Demzufolge ist entweder der innere Chip-Bereich oder der äußere, chip-freie Bereich zu behandeln.

Danach schlägt die Erfindung in ihrer allgemeinsten Ausführungsform eine. Vorrichtung zur Flüssigkeitsbehandlung eines definierten Abschnitts eines scheibenförmigen Gegenstandes, insbesondere eines Wafers, vor, bestehend aus Haltemittel zum Halten des scheibenförmigen Gegenstandes, einer Maske, die in Form und Größe dem zu behandelnden Bereich des definierten Abschnittes der mit der Flüssigkeit behandelt werden soll entspricht, Distanzmittel, die die Maske und den scheibenförmigen Gegenstand in einem solchen definierten geringen Abstand zueinander halten, dass Flüssigkeit zwischen der Maske und dem definierten Bereich des scheibenförmigen Gegenstandes durch Kapillarkräfte gehalten. werden kann, und einer Flüssigkeitsleitung, die auf die der Maske zugewandte Oberfläche des scheibenförmigen Gegenstandes gerichtet ist, gemäß Anspruch 1.

Haltemittel können unter anderem sein, Vakuumgreifer, Greifmittel, die den scheibenförmigen Gegenstand an seinem umfangsseitigen Rand berühren oder ein sogenannter Bernoulli-Chuck.

Die Maske ist so ausgestaltet, dass diese, wenn sich ein scheibenförmiger Gegenstand (Wafer) auf dem Träger befindet, den scheibenförmigen Gegenstand (Wafer) nicht berührt, d.h. zwischen dem Wafer und der Maske ein Spalt bleibt. Die Maske normal auf die Hauptoberfläche des Wafers projiziert gibt den Bereich des Wafers an, der mit der Flüssigkeit behandelt wird. Das Material der Oberfläche der Maske, die dem scheibenförmigen Gegenstand zugewandt ist, ist so auszuwählen, dass es von der Flüssigkeit so gut benetzt wird, dass Flüssigkeit in den Spalt zwischen scheibenförmigem Gegenstand und Maske durch Kapillarkraft gehalten wird. Die Summe der beiden Benetzungswinkel der Flüssigkeit einerseits gegen den scheibenförmigen Gegenstand und andererseits gegen die Maske sollte kleiner als 180° sein, vorzugsweise kleiner 150°. Bei vorher ausgewählter Maskenoberfläche kann dies selbstverständlich auch durch der Flüssigkeit zugefügte Additive (Netzmittel) erreicht werden.

Ein Vorteil der. erfindungsgemäßen Vorrichtung ist es, dass der zu behandelnde Gegenstand genau in dem zu behandelnden Bereich von der Behandlungsflüssigkeit benetzt wird und zwar ohne dass dieser Bereich von einem festen Körper berührt wird. Gleichzeitig wird vermieden; dass Flüssigkeitströpfchen auf Bereiche gelangen, die nicht behandelt werden sollen bzw. dürfen.

Durch die Flüssigkeitsleitung, die auf die der Maske zugewandte Oberfläche des scheibenförmigen Gegenstandes gerichtet ist, kann die Oberfläche, deren definierter erster Bereich mit einer ersten Flüssigkeit behandelt worden ist, auch mit einer zweiten Flüssigkeit behandelt werden und zwar in einem zweiten Bereich der vom ersten verschieden ist. Dieser zweite Bereich kann flächenmäßig größer sein und auch den ersten Bereich vollkommen überdecken. Ist die erste Flüssigkeit z.B. eine Ätzflüssigkeit so kann diese mit Hilfe der zweiten Flüssigkeit (z.B. entionisiertes Wasser) restlos von der der Maske zugewandten Oberfläche entfernen. Gleichzeitig kann dadurch auch die Maske gereinigt bzw. von der ersten Flüssigkeit befreit werden.

Bei einer vorteilhaften Ausführungsform besitzt die Maske die Form eines Ringes. Der Ring kann in diesem Fall einen Innendurchmesser besitzen, der kleiner ist als der Außendurchmesser des scheibenförmigen Gegenstandes, und einen Außendurchmesser, der mindestens gleich groß ist wie der Außendurchmesser des scheibenförmigen Gegenstandes. Dies ist dann notwendig, wenn die zu behandelnde Fläche ebenfalls die Form eines Ringes aufweist, wie dies z.B. beim Entfernen einer Schicht von einem definierten Randbereich eines Halbleiterwafers der Fall ist.

Vorteilhaft ist, wenn die Distanzmittel die Maske und den scheibenförmigen Gegenstand in einem Abstand von 0,05 bis 1 mm zueinander halten. Bei der Verwendung von dünnflüssigen Medien wie Wasser, Lösungsmittel oder diverse Säuren in wässriger Lösung, wird dadurch verhindert, dass die Flüssigkeit leicht aus dem Kapillarbereich zwischen Maske und scheibenförmigen Gegenstand herausrinnt.

Bei einer Ausführungsform besteht das Distanzmittel aus Greifelementen, die in direktem Kontakt mit dem scheibenförmigen Gegenstand sind und direkt oder indirekt mit der Maske verbunden sind. Dies kann z.B. durch ein außen liegendes Gestänge (indirekt) oder durch z.B. umfangsseitig angeordnete Stifte (direkt) erfolgen.

Bei einer weiteren Ausführungsform sind Maske und Haltemittel relativ zueinander bezüglich einer Rotation um eine senkrecht auf die Maske stehende Achse unbeweglich. Maske und Haltemittel rotieren also beide nicht oder rotiert z.B. das Haltemittel, und mit ihm der scheibenförmige Gegenstand, so rotiert die Maske mit der selben Geschwindigkeit mit. Die fehlende Relativbewegung der Maske zur Oberfläche des scheibenförmigen Gegenstandes ist von Vorteil, wenn die im Kapillarbereich zwischen Maske und scheibenförmigen Gegenstand gehaltene Flüssigkeit, während dem sie in diesem Bereich gehalten wird, möglichst wenig Bewegung in sich erfahren soll. Dadurch wird verhindert; in den Bereich der von der Flüssigkeit nicht behandelt werden soll gelangt.

Das Distanzmittel kann aus einer Gaszuführeinrichtung bestehen, die direkt oder indirekt mit der Maske verbunden ist und gegen den scheibenförmigen Gegenstand gerichtet ist, wodurch der scheibenförmigen Gegenstand auf einem Gaspolster gehalten werden kann. Diese Gaszuführeinrichtung kann z.B. eine oder mehrere senkrecht oder schräg zur Oberfläche des scheibenförmigen Gegenstand angeordnete-Düsen oder eine Ringdüse sein. Durch Wahl des Drucks bzw. des Gas-Volumenstroms kann bei vorgegebener Form, Größe und Anordnung der Gaszuführeinrichtung der Abstand zwischen der Gaszuführeinrichtung und dem scheibenförmigen Gegenstand und somit der zwischen Maske und scheibenförmigen Gegenstand exakt und reproduzierbar eingestellt werden.

Weiters kann die erfindungsgemäße Vorrichtung in einer Ausführungsform Distanzveränderungsmittel aufweisen, die den Abstand zwischen der Maske und dem scheibenförmigen Gegenstand zueinander so vergrößern können, dass Flüssigkeit, die sich zwischen Maske und scheibenförmigen Gegenstand befindet nicht mehr durch Kapillarkräfte gehalten wird. Dabei kann es sich um einen Bewegungsmechanismus handeln, der die Haltemittel senkrecht zur Oberfläche des scheibenförmigen Gegenstandes bewegen kann oder um einen Bewegungsmechanismus, der die Maske entsprechend bewegen kann. Es kann aber auch der scheibenförmige Gegenstand direkt entsprechend bewegt werden. Ein Distanzveränderungsmittel kann z.B. ein zusätzlichen Greifer geschehen (z.B. Löffel) oder es sind Stifte (Liftingpins) die den scheibenförmigen Gegenstand anheben. Auch kann das Distanzveränderungsmittel eine Gaszuführeinrichtung sein deren Betriebszustand derart geändert werden kann, dass der scheibenförmige Gegenstand angehoben oder gesenkt wird.

Durch ein derartiges Distanzveränderungsmittel werden Maske und scheibenförmiger Gegenstand so weit von einander entfernt, dass Flüssigkeit die sich im Bereich dazwischen befunden hat wieder entfernt werden kann. Von Vorteil ist es, wenn das Distanzveränderungsmittel den Abstand um mindestens 0,2 mm, vorzugsweise mindestens 0,5 mm vergrößern kann.

Vorteilhaft ist es wenn die Distanzveränderungsmittel derart ausgestaltet sind, dass diese den Abstand zwischen der Maske und dem scheibenförmigen Gegenstand während oder unmittelbar nach der Flüssigkeitsbehandlung verändern können. Dies ist z.B. im Fall der Gaszuführeinrichtung als Distanzveränderungsmittel möglich.

Bei einer Ausführungsform sind Distanzveränderungsmittel und Distanzmittel derart ausgestaltet, dass Elemente des Distanzmittel gleichzeitig Elemente des Distanzveränderungsmittels sind. Hat das .Distanzmittel Stifte mit entsprechenden Kerben, die umfangsseitig den scheibenförmigen Gegenstand berühren und dadurch in definiertem Abstand Zur Maske halten, so sind diese Stifte gleichzeitig Element des Distanzveränderungsmittels, wenn sie normal zur Oberfläche des scheibenförmigen Gegenstandes bewegt werden können.

Bei einer Ausführungsform sind im wesentlichen senkrecht zu einer Hauptoberfläche des scheibenförmigen Gegenstandes,. die Position des scheibenförmigen Gegenstandes umfangsseitig begrenzende Führungselemente angeordneten. Dadurch wird die Position des .scheibenförmigen-Gegenstandes gegen die Maske bezüglich einer Verschiebung fixiert. Der. Abstand der Führungselemente zum Mittelpunkt des scheibenförmigen Gegenstandes kann veränderlich sein.

Auch kann dieser Abstand auf ein so kleines Maß verringerbar sein, dass die Führungselemente den scheibenförmigen Gegenstand festhalten können, und insofern auch Element des Haltemittel sind. Das Haltemittel kann auch sowohl aus Führungselementen als auch einer Gaszuführeinrichtung bestehen.

Das Distanzveränderungsmittel kann aus einer Gaszuführeinrichtung bestehen, die direkt oder indirekt mit der Maske verbunden ist und gegen eine Hauptoberfläche des Gegenstandes gerichtet ist, wodurch der scheibenförmigen Gegenstand auf einem Gaspolster gehalten werden kann. Dabei muss die Gaszuführeinrichtung nicht notwendigerweise gleichzeitig Distanzmittel sein, denn das Distanzmittel kann eine einfache mechanische Auflage sein (z.B. Stifte, Distanzring) und die Gaszuführeinrichtung nur dann Gas führen, wenn der scheibenförmige Gegenstand angehoben wird.

Jedoch kann es sich bei dem Distanzmittel und bei dem Distanzveränderungsmittel um im wesentlichen die selbe Gaszuführeihrichtung handeln, wobeiMittel vorgesehen sind, durch die die Gaszuführeinrichtung in mindestens zwei verschiedene Betriebszustände versetzt werden kann. Durch diese mindestens zwei verschiedenen Betriebszustände können sich mindestens zwei verschiedene Abstände zwischen dem scheibenförmigen Gegenstand und der Maske einstellen. Diese Mittel sind z.B. Mittel die den Druck und/oder den Volumenstrom des der Gaszuführeinrichtung zugeführten Gases verändert werden können. Solche Mittel sind z.B. Reduzierventile oder Ventile die zusätzliche Düsen der Gaszuführeinrichtung öffnen und schließen. Bei höherem Volumenstrom nimmt der scheibenförmige Gegenstand dann einen größeren Abstand zur Maske ein als bei niedrigerem. Andere Mittel können die Größe, die Form und/oder die Ausrichtung der Gaszuführeinrichtung verändern. Werden z.B. bewegliche Düsen eingesetzt, so wird der scheibenförmige, Gegenstand umso stärker angehoben je größer der Winkel (0° bis 90°) zwischen Düsenausrichtung und Oberfläche des scheibenförmigen Gegenstandes, gegen die die Düse gerichtet ist, gewählt wird.

Bei Distanzmittel und Distanzveränderungsmittel kann es sich auch um zwei Gaszuführeinrichtungen handeln die getrennt von einander ansteuerbar sind.

Bei einer Ausführungsform können die Haltemittel in Rotation versetzt werden, wodurch der scheibenförmige Gegenstand rotiert. Dies ist, wenn auch nicht notwendig, so doch vorteilhaft, da die Behandlungsflüssigkeit sowohl vom Träger als auch von der Waferkante abgeschleudert werden kann.

Dieser Spalt zwischen der Maske und dem scheibenförmigen Gegenstand beträgt in einer Ausführungsform 0,05 bis 1 mm, vorteilhafterweise 0,1 bis 0,5 mm. Dadurch bildet sich zwischen dem Wafer und der Gasleitvorrichtung eine Art Kapillare aus, von der Flüssigkeit, die um die Waferkante geflossen ist, angesaugt wird. Der Innendurchmesser, der von der Flüssigkeit benetzten, der Gasleitvorrichtung zugewandten Oberfläche ist kleiner als der Innendurchmesser der Ringfläche der Gasleitvorrichtung.

Es ist von Vorteil, wenn die dem scheibenförmigen Gegenstand zugewandte Fläche der Gasleitvorrichtung zu den Hauptoberflächen des scheibenförmigen Gegenstand parallel ist.

Der Spalt zwischen dem scheibenförmigen Gegenstand (Wafer) und der Gasleitvorrichtung ist dadurch im gesamten Randbereich gleich groß.

Eine Ausführungsform sieht vor,-daß der Träger in Rotation versetzt werden kann. Dies ist, wenn auch nicht notwendig, so doch vorteilhaft, da die Behandlungsflüssigkeit sowohl vom Träger als auch von der Waferkante abgeschleudert werden kann. Ist der Träger während der Flüssigkeitsbehandlung nicht in Rotation, so kann die. Flüssigkeit durch einen Gasstrom (aus einer Gaszuführeinrichtung) abgeblasen werden.

Weitere Einzelheiten, Merkmale und Vorteile der Erfindung ergeben sich aus der nachstehenden Beschreibung der in den Zeichnungen gezeigten Ausführungsbeispiele der Erfindung

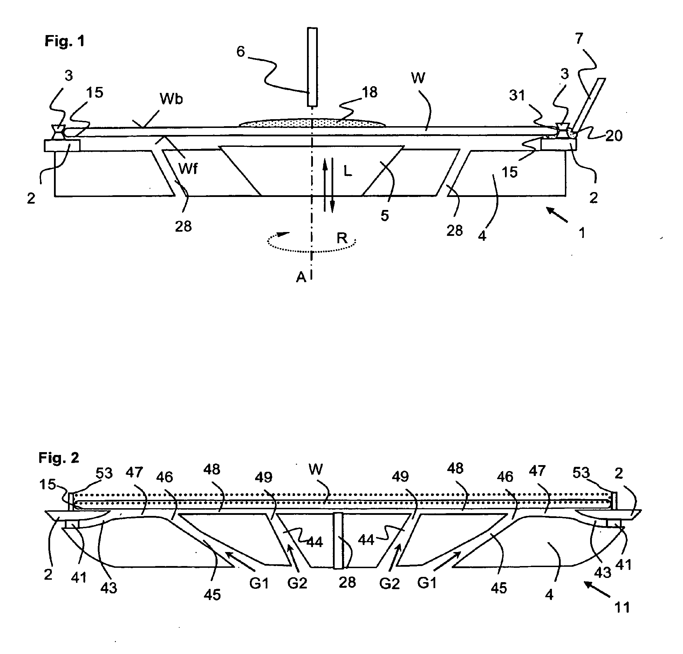

Es zeigt Fig. 1-5 schematisch Achsialschnitte 5 verschiedener erfindungsgemäßer Ausführungsformen.

Die Fig: 6-8 zeigen einen schematischen Achsialschnitt einer Ausführungsform nach Fig. 1 in verschiedenen Betriebszuständen.

Fig. 1 zeigt eine Ausführungsform der erfindungsgemäßen Vorrichtung 1. Die Vorrichtung 1 besteht aus einem im wesentlichen runden Grundkörper 4 auf den die Maske 2, die hier die Form eines Ringes besitzt, konzentrisch angebracht ist. Der Ring 2 kann aber auch aus dem Grundkörper herausgearbeitet sein. Der Ring 2 besitzt einen Außendurchmesser der größer und einen Innendurchmesser der kleiner ist als der Außendurchmesser des Wafers. Stifte 3, die auf dem Ring 4 angebracht sind, halten den Wafer W umfangsseitig. Die Stifte 3 besitzen eine Kerbe 31 die in den Waferrand einrastet und so den Wafer in einer definierten horizontalen Lage halten. Die Stifte 3 mit ihren Kerben 31 stellen insofern die Distanzmittel zur Maske 2 dar. Zwischen der Maske 2 und der der Maske zugewandten Waferoberfläche Wf stellt sich dadurch ein definierter Spalt 15 ein. Die Stifte 3 werden über einen nicht dargestellten Mechanismus relativ zur Achse A bewegt, um den Wafer fest zu greifen und zum Entnehmen oder zum Anheben des Wafers diesen wieder freizugeben. Innerhalb des Grundkörpers 4 ist ein Hebemechanismus 5 (Distanzveränderungsmittel) angeordnet; der in Pfeilrichtung L auf und ab bewegt werden kann, und insofern den Abstand zwischen dem Wafer W und der Maske 2 verändern kann. Der Hebemechanismus besteht aus einem Träger, der eine dem Wafer zugewandte im wesentlichen ebene und zum Wafer parallel Fläche besitzt, die wenn der Träger angehoben wird erst den Wafer an seiner unteren Oberfläche Wf berührt und dann den Wafer anhebt. Die gesamt Vorrichtung 1, und mit ihr der Wafer, kann um die Waferachse A rotieren.

Die Behandlungsflüssigkeit kann entweder durch die außerhalb in der Nähe des Waferrandes angebrachte Düse 7 oder durch eine Düse 6 aufgebracht werden, die gegen die der Maske 2 abgewandte Waferoberfläche Wb gerichtet ist. Im ersten Fall (Düse 7) wird eine Flüssigkeitsmenge 20 unmittelbar beim Waferrand auf die Maske 2 aufgebracht. Die Flüssigkeit wird sodann von dem kapillarartigen Spalt 15 eingezogen und benetzt so genau den Bereich der der Maske 2 zugeordneten Waferoberfläche Wf, der von der Maske 2 überlappt wird. Im zweiten Fall (Düse 6) wird die Flüssigkeitsmenge 18 auf die der Maske 2 abgewandte Oberfläche Wf z.B. in deren Zentrum aufgetragen, die Flüssigkeit rinnt sodann radial nach außen zum Waferrand, was durch Rotation des Wafers unterstützt werden kann. Daraufhin fließt die Flüssigkeit um den Waferrand und wird vom Spalt 15 eingezogen. In beiden Fällen kann der Wafer während der gesamten Flüssigkeitsbehandlung rotieren (R), was den Vorteil hat, dass überschüssige Flüssigkeit, die nicht in den Spalt 15 eindringt, nicht unkontrolliert über die Maske 2 nach unten abfließt, sondern kontrolliert abgeschleudert wird. Anschließend wird auf die der Maske 2 zugewandte Waferoberfläche Wf eine zweite Flüssigkeit (z.B. deionisiertes Wasser) über die Flüssigkeitsleitung 28 aufgebracht, gleichzeitig rotiert der Täger 4, wodurch die zweite Flüssigkeit die Flüssigkeit die sich im Spalt 15 befindet verdrängt. Gleichzeitig, davor oder auch danach wird der Wafer mit dem Hebemechanismus 5 angehoben.

Fig. 2 zeigt eine Ausführungsform. Die Vorrichtung besteht aus einem Träger 11, der einen Grundkörper 4 und einem Ring 2, der über die Abstandskörper 41 beabstandet zum Grundkörper auf diesem befestigt ist. Der Ring ist über die Abstandsteile 41 Auf dem Ring 2 sind Stifte 53 befestigt, die bezogen auf die Rotationsachse A des Trägers 11 radial nach außen bewegt werden können und den Wafer W umfangsseitig umschließen können. Die Stifte 53 haben die Form kleiner Zylinder mit ihren Achsen senkrecht zur Oberfläche des Wafers. In den Grundkörper 4 sind Gaskanäle 44 und 45 eingearbeitet, die in Gasdüsen 46 und 49 münden gegen die dem Träger 11 zugewandte Oberfläche des Wafers gerichtet sind. Die Düsen 46 und 49 sind schräg nach außen gestellt, wobei die weiter innen liegenden Düsen 49 weniger schräg gestellt sind als die weiter außen liegenden Düsen 46, d.h. der austretende Gasstrom G1 der weiter außen liegenden Düsen 46 trifft in einem flacheren Winkel auf die Waferoberfläche auf, als der austretende Gasstrom G2 der weiter innen liegenden Düsen. Der Abstand des Grundkörpers 4 zum Wafer W ist im Bereich 48 zwischen den inneren und äußeren Düsen 49 und 46 kleiner als im Bereich 47 außerhalb der äußeren Düsen 46. Sowohl die innen liegenden Düsen 49 als auch die außen liegenden Düsen 46 können wahlweise entweder eine Vielzahl kreisförmig angeordnete Düsen sein, oder die Form von Ringdüsen besitzen.

Diese Vorrichtung kann auf im wesentlichen zwei verschiedene Arten betrieben werden. Bei der ersten Betriebsart können der äußere Gasstrom G1 und der innere Gasstrom G2 getrennt von einander ein und ausgeschaltet werden. Ist nur der erste Gasstrom G1 eingeschalten so strömt Gas nur über den Bereich 47. Der Wafer W wird nur leicht angehoben, wodurch sich ein kleiner kapillarartiger Spalt 15 zwischen Maske 2 und Wafer W ausbildet. Wird in diesem ersten Betriebszustand nun Flüssigkeit, wie in der Beschreibung zu Fig. 1 beschrieben, aufgetragen, so wird diese in den Spalt 15 eingezogen. Wird nun zusätzlich oder statt des Gasstromes G1 der Gasstrom G2 eingeschalten so strömt Gas nicht nur über den Bereich 47 außerhalb der äußeren Düsen 46, sondern auch über den Bereich 48 zwischen den äußeren und den inneren Düsen. Durch diesen zweiten Betriebszustand wird der Wafer W etwas angehoben, dargestellt durch die gepunktete Linie. Der Waferrand gleitet dabei entlang der Zylinderfläche der Stifte 53. Dieses leichte Anheben des Wafers reicht aus dafür, dass die Flüssigkeit im Spalt 15 zwischen Maske und Wafer nicht mehr durch Kapillarkräfte gehalten wird. Die Flüssigkeit kann aus diesem Bereich entfernt werden, was durch den Gasstrom geschieht, d.h. die Tropfen werden radial nach außen hin weggeblasen. Unterstützt kann die Entfernung der Flüssigkeit dadurch werden, dass der gesamte Träger 11 und mit ihm der Wafer rotiert. Zusätzlich kann durch eine Düse, welche durch die Flüssigkeitsleitung 28 gespeist wird, Spülflüssigkeit durch den Grundkörper 4 auf die dem Träger zugewandte Waferoberfläche geführt werden, wodurch die im Spalt 15 befindliche Flüssigkeit zusätzlich verdrängt wird. Diese Spülflüssigkeit muss ihrerseits selbst verständlich auch wieder entfernt werden.

Bei der zweiten Betriebsart werden beide Gasströme G1 und G2 gemeinsam geschaltet. In einem ersten Betriebszustand strömt weniger Gas als in einem zweiten Betriebszustand, wodurch der Wafer im zweiten Betriebszustand eine Lage einnimmt, bei der sein Abstand zu der Maske 2 größer ist, als im ersten Betriebszustand. Der Abstand des Wafers W zur Maske 2 im ersten Betriebszustand ist z.B. 0,5 mm und im zweiten 0,8 mm.

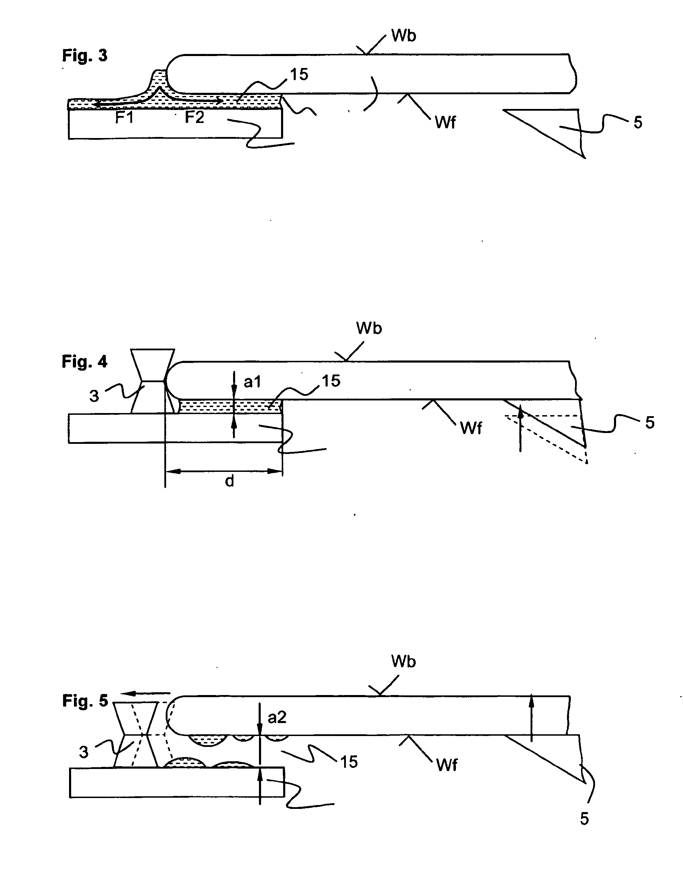

Anhand der Fig. 3-5 soll nun die Betriebsweise einer erfindungsgemäßen Vorrichtung beschrieben werden, wobei von der Ausführungsform der Fig. 1 ausgegangen wird. Zuerst wird der Wafer W in die Nähe der Maske 2 gebracht, wodurch sich der Spalt 15 ausbildet. Der definierte Abstand zwischen der Maske 2 und dem Wafer wird durch Distanzmittel gewährleistet, hier die Stifte 3 (Fig. 3) mit Kerben. Nun wird Flüssigkeit entweder auf die der Maske abgewandte Waferoberfläche Wb oder direkt an den Waferrand aufgetragen. Die Flüssigkeit tritt zum Teil in den Spalt 15 ein (F2). Der überschüssige Teil der Flüssigkeit F1 rinnt ab bzw. wird wenn die Maske und/oder der Wafer rotieren abgeschleudert. Die Flüssigkeit kann nicht weiter nach innen rinnen als die innere Kontur der Maske 2 ist, d.h. sie dringt nur bis zum Punkt P vor. Der Abstand a1 zwischen der Maske 2 und dem Wafer wird so klein gewählt, dass die Flüssigkeit durch Kapillarkräfte innerhalb des Spaltes 15 gehalten wird, und dort die Waferoberfläche behandelt. Ein Hebemechanismus 5 tritt nun in Kontakt mit der der Maske 2 zugewandten Waferoberfläche Wf, die Stifte 3 werden nun geöffnet (B) und der Hebemechanismus 5 hebt den Wafer soweit an, dass der Flüssigkeitsfilm im Spalt 15 reißt und nur mehr Tropfen 16 auf der Maske und/oder der Waferoberfläche bleiben. Diese Tropfen 16 können nun abgespült, abgeblasen und/oder abgeschleudert werden.

## Patentansprüche

1. Vorrichtung zur Flüssigkeitsbehandlung eines definierten, Abschnitts eines scheibenförmigen Gegenstandes (W), insbesondere eines Wafers, bestehend aus
1.1 Haltemittel-(3, 53) zum Halten des scheibenförmigen Gegenstandes
1.2 einer Maske (2) die in Form und Größe dem zu behandelnden Bereich des definierten Abschnittes der mit der Flüssigkeit behandelt werden soll entspricht,
1.3 Distanzmittel (3, 31, 45, 41), die die Maske und den.scheibenförmigen Gegenstand in einem solchen definierten geringen Abstand zueinander halten, dass Flüssigkeit zwischen der Maske und dem definierten Bereich des scheibenförmigen Gegenstandes (15) durch Kapillarkräfte gehalten werden kann,
1.4 einer Flüssigkeitsleitung (28), die auf die der Maske zugewandte Oberfläche des scheibenförmigen Gegenstandes gerichtet ist.

2. Vorrichtung nach Anspruch 1, bei der die Maske (2) die Form eines Ringes besitzt.

3. Vorrichtung nach Anspruch 2, bei der der Ring einen Innendurchmesser besitzt, der kleiner ist als der Außendurchmesser des scheibenförmigen Gegenstandes, und einen Außendurchmesser, der mindestens gleich groß ist wie der Außendurchmesser des scheibenförmigen Gegenstandes.

4. Vorrichtung nach Anspruch 1, bei der die Distanzmittel die. Maske und den scheibenförmigen Gegenstand in einem Abstand (a1) von 0,05 bis 1 mm hatten.

5. Vorrichtung nach Anspruch 1, wobei das Distanzmittel aus Greifelementen (3, 53) besteht, die in direktem, Kontakt mit dem scheibenförmigen Gegenstand sind und direkt oder indirekt mit der Maske (2) verbunden sind.

6. Vorrichtung nach Anspruch 1, bei der Maske und Haltemittel relativ zueinander bezüglich einer Rotation um eine senkrecht auf die Maske stehende Achse (A) unbeweglich sind.

7. Vorrichtung nach Anspruch 1, wobei das Distanzmittel aus einer Gaszuführeinrichtung (45, 46) besteht, die direkt oder indirekt (41) mit der Maske (2) verbunden ist und gegen den scheibenförmigen Gegenstand gerichtet ist, wodurch der scheibenförmige Gegenstand auf einem Gaspolster gehalten werden kann.

8. Vorrichtung nach Anspruch 1, die Distanzveränderungsmittel (5, 44, 49) aufweist, die den Abstand (a1) zwischen der Maske und dem scheibenförmigen Gegenstand zueinander so vergrößern (a2) können, dass Flüssigkeit, die sich zwischen Maske und scheibenförmigen Gegenstand befindet, nicht mehr durch Kapillarkräfte gehalten wird.

9. Vorrichtung nach Anspruch 8. wobei die Distanzveränderungsmittel derart ausgestaltet sind, dass diese den Abstand zwischen der Maske und dem scheibenförmigen Gegenstand während oder unmittelbar nach der Flüssigkeitsbehandlung verändern können.

10. Vorrichtung nach Anspruch 8, bei dem die Elemente des Distanzmittel gleichzeitig Elemente des Distanzveränderungsmittels sind.

11. Vorrichtung nach Anspruch 1, mit im wesentlichen senkrecht zu einer Hauptoberfläche des scheibenförmigen Gegenstandes angeordneten, die Position des scheibenförmigen Gegenstandes umfangsseitig begrenzenden Führungselementen (3, 53).

12. Vorrichtung nach Anspruch 11, bei der die Haltemittel aus Führungselementen (53) und einer Gaszuführeinrichtung (45,46) bestehen.

13. Vorrichtung nach Anspruch 10, bei der das Distanzveränderungsmittel aus einer Gaszuführeinrichtung (44, 49) besteht, die direkt oder indirekt mit der Maske (2) verbunden ist und gegen eine Hauptoberfläche (Wf) des scheibenförmigen Gegenstandes gerichtet ist, wodurch der scheibenförmigen Gegenstand auf einem Gaspolster gehalten werden kann.

14. Vorrichtung nach Anspruch 13, bei dem es sich bei dem Distanzmittel und bei dem Distanzveränderungsmittel um im wesentlichen die selbe Gaszuführeinrichtung (44, 45,46,49) handelt und Mittel vorgesehen sind wodurch die Gaszuführeinrichtung in mindesten zwei verschiedene Betriebszustände versetzt werden.kann, wodurch sich zwei verschiedene Abstände zwischen dem scheibenförmigen Gegenstand und der Maske einstellen können.

15. Vorrichtung nach Anspruch 1, bei der die Haltemittel in Rotation (R) versetzt werden können.

## Claims

1. A device for the liquid treatment of a defined section of a disc-shaped object (W), in particular of a wafer, comprising
1.1 retention means (3, 53) for retaining the disc-shaped object
1.2 a mask (2), which corresponds in shape and size to the area to be treated of the defined section which is to be treated using the liquid,
1.3 spacer means (3, 31, 45, 41), which retain the mask and the disc-shaped object at such a defined small distance to one another that liquid may be held between the mask and a defined area of the disc-shaped object (15) by capillary forces,
1.4 a liquid line (28), which is directed toward the surface of the disc-shaped object facing toward the mask.

2. The device according to Claim 1, wherein the mask (2) has the shape of a ring.

3. The device according to Claim 2, wherein the ring has an internal diameter which is less than the external diameter of the disc-shaped object, and an external diameter which is at least equal to the external diameter of the disc-shaped object.

4. The device according to Claim 1, wherein the spacer means retain the mask and the disc-shaped object at a distance (a1) of 0.05 to 1 mm.

5. The device according to Claim 1, wherein the spacer means comprise gripper elements (3, 53), which are in direct contact with the disc-shaped object and are directly or indirectly connected to the mask (2).

6. The device according to Claim 1, wherein mask and retention means are immobile in relation to one another in regard to a rotation around an axis (A) standing vertically on the mask.

7. The device according to Claim 1, wherein the spacer means comprise a gas feed unit (45, 46), which is directly or indirectly (41) connected to the mask (2) and is directed toward the disc-shaped object, whereby the disc-shaped object may be retained on a gas cushion.

8. The device according to Claim 1, which has distance changing means (5, 44, 49), which may increase the distance (a1) between the mask and the disc-shaped object in such a way (a2) that liquid which is located between mask and disc-shaped object is no longer retained by capillary forces.

9. The device according to Claim 8, wherein the distance changing means are implemented in such a way that they may change the distance between the mask and the disc-shaped object during or immediately after the liquid treatment.

10. The device according to Claim 8, wherein elements of the spacer means are simultaneously elements of the distance changing means.

11. The device according to Claim 1, having guide elements (3, 53) which are situated essentially perpendicular to a main surface of the disc-shaped object and delimit the position of the disc-shaped object around the circumference.

12. The device according to Claim 11, wherein the retention means comprise guide elements (53) and a gas feed unit (45, 46).

13. The device according to Claim 10, wherein the distance changing means comprise a gas feed unit (44, 49), which is connected directly or indirectly to the mask (2) and is directed toward a main surface (Wf) of the disc-shaped object, whereby the disc-shaped object may be retained on a gas cushion.

14. The device according to Claim 13, wherein the spacer means and the distance changing means are essentially the same gas feed unit (44, 45, 46, 49) and means are provided, whereby the gas feed unit may be set in at least two different operating states, whereby two different distances may be set between the disc-shaped object and the mask.

15. The device according to Claim 1, wherein the retention means may be set into rotation (R).

## Revendications

1. Dispositif pour le traitement par un liquide d'une partie définie d'un objet (W) en forme de disque, en particulier d'une plaquette, composé :
1.1 de moyens de fixation (3, 53) pour la fixation de l'objet en forme de disque
1.2 d'un masque (2) dont la forme et la taille correspondent à la zone à traiter de la partie définie qui doit être traitée avec le liquide,
1.3 de moyens d'écartement (3, 31, 45, 41), qui retiennent le masque et l'objet en forme de disque à une faible distance définie l'un de l'autre telle que le liquide puisse être retenu entre le masque et la partie définie de l'objet en forme de disque (15) par les forces de capillarité,
1.4 une conduite de liquide (28) dirigée vers la surface de l'objet en forme de disque tournée vers le masque

2. Dispositif selon la revendication 1, dans lequel le masque (2) a la forme d'un anneau.

3. Dispositif selon la revendication 2, dans lequel l'anneau a un diamètre intérieur plus petit que le diamètre extérieur de l'objet en forme de disque et un diamètre extérieur au moins aussi grand que le diamètre intérieur de l'objet en forme de disque.

4. Dispositif selon la revendication 1, dans lequel les moyens d'écartement retiennent le masque et l'objet en forme de disque à une distance (a1) de 0,05 à 1 mm.

5. Dispositif selon la revendication 1, dans lequel le moyen d'écartement se compose d'éléments de préhension (3, 53) qui sont en contact direct avec l'objet en forme de disque et sont directement ou indirectement reliés au masque (2).

6. Dispositif selon la revendication 1, dans lequel le masque et les moyens de fixation sont immobiles l'un par rapport à l'autre dans le sens d'une rotation autour d'un axe (A) vertical perpendiculaire au masque.

7. Dispositif selon la revendication 1, dans lequel le moyen d'écartement se compose d'un dispositif d'arrivée de gaz (45, 46) qui est directement ou indirectement (41) relié au masque (2) et qui est dirigé vers l'objet en forme de disque, de sorte que l'objet en forme de disque peut être retenu sur un coussin d'air.

8. Dispositif selon la revendication 1, présentant des moyens de modifier la distance (5, 44, 49) qui peuvent augmenter (a2) la distance (a1) entre le masque et l'objet en forme de disque de telle sorte que le liquide qui se trouve entre le masque et l'objet en forme de disque n'est plus retenu par les forces de capillarité.

9. Dispositif selon la revendication 8, dans lequel les moyens de modifier la distance sont conformés de telle sorte qu'ils peuvent modifier la distance entre le masque et l'objet en forme de disque pendant ou immédiatement après le traitement par le liquide.

10. Dispositif selon la revendication 8, dans lequel les éléments du moyen d'écartement sont en même temps des éléments du moyen de modifier la distance.

11. Dispositif selon la revendication 1, avec des éléments de guidage (3, 53) disposés de façon sensiblement perpendiculaire à une surface principale de l'objet en forme de disque et qui limitent la position de l'objet en forme de disque sur sa circonférence.

12. Dispositif selon la revendication 11, dans lequel les moyens de fixation se composent d'éléments de guidage (53) et d'un dispositif d'arrivée de gaz (45,46).

13. Dispositif selon la revendication 10, dans lequel le moyen de modifier la distance se compose d'un dispositif d'arrivée de gaz (44, 49) qui est relié directement ou indirectement avec le masque (2) et qui est dirigé vers une surface principale (Wf) de l'objet en forme de disque, de sorte que l'objet en forme de disque peut être retenu sur un coussin de gaz.

14. Dispositif selon la revendication 13, dans lequel le moyen d'écartement et le moyen de modifier la distance sont formés pour l'essentiel par le même dispositif d'arrivée de gaz (44, 45,46,49) et des moyens sont prévus pour amener le dispositif d'arrivée de gaz dans au moins deux états de fonctionnement différents, de sorte que deux distances différentes peuvent se créer entre l'objet en forme de disque et le masque.

15. Dispositif selon la revendication 1, dans lequel les moyens de fixation peuvent être déplacés en rotation (R).
